# EUROPEAN PATENT APPLICATION

(11) **EP 0 662 722 A2**
(43) Date of publication of application: **12.07.1995**
(21) Application number: 95300084.1
(22) Date of filing: 06.01.1995
(51) Int. Cl.: H01L 31/0352, H01L 31/0224, H01L 31/052, H01L 31/042

(54) **Solar cell arrangement**

(30) Priority: 07.01.1994 JP 23004/94
(71) Applicant: HONDA GIKEN KOGYO KABUSHIKI KAISHA, Minato-ku Tokyo (JP)
(72) Inventor: Hirose, Yoshitsugu, Wako-shi, Saitama-ken (JP)
(74) Representative: Leale, Robin George

(57) **Abstract**

A solar cell arrangement includes a plurality of elongate solar cell elements (3) each having an elongate first electrode (1) and a photovoltaically operative layer (2) coaxially disposed around the first electrode, and a generaly plate-like second electrode (4) having one side surface (4A) on which the solar cell elements are mounted. The one side surface of the second electrode is a light-reflective surface, and is configured such that light reflected from the one side surface is gathered onto the outer peripheral surface of each of the solar cell elements.

## Description

This invention relates to a solar cell arrangement comprising a plurality of solar cell elements.

Conventional solar cells in general are comprised of thin film-shaped solar cell elements, and therefore require a large mounting area and hence have a low space factor. Further, conventional solar cells of a type in which a thin film-shaped electrode is disposed on a surface of the photovoltaically operative layer have the disadvantage that the electrode provides a considerable shading effect and has large electric resistance itself, whereby the photoelectric conversion efficiency is low.

To overcome the above-mentioned disadvantages of the conventional solar cells, a solar cell arrangement has been proposed, e.g. by US Patent No. 4,913,744, which can be manufactured in a simplified and more economical fashion, and has an improved space factor as well as an improved photoelectric conversion efficiency.

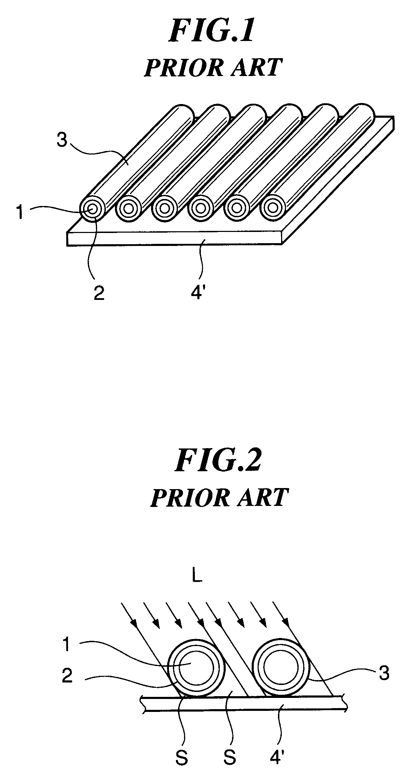

Specifically, as shown in Fig.1, this proposed solar cell arrangement is comprised of a plurality of wire-like or thread-like solar cell elements 3 which are arranged in mutually parallel juxtaposed relationship and which each comprise a wire-like or thread-like center electrode 1 as a positive electrode, a photovoltaically operative layer 2 disposed coaxially around the center electrode 1, and a generally plate-like electrode 4' having a flat surface on which the solar cell elements 3 are mounted. The electrode 4' serves as a common negative electrode for all the solar cells 3.

In this proposed solar cell arrangement, the outer peripheral surface of the photovoltaically operative layer 2 around the elongate center electrode 1 acts as a plane of incidence of light, and consequently it is unavoidable that shaded portions S are formed at a side of the outer peripheral surface of the layer 2 opposite to the side thereof on which the incident light L impinges on the outer peripheral surface. As a result, the photoelectric conversion efficiency is lowered by a reduced electromotive force corresponding to the shaded portions S.

It is an object of the invention to provide a solar cell arrangement which is capable of reducing shaded portions dependant on the direction of incident light, to thereby achieve efficient irradiation of light on the solar cell elements and hence improve the photoelectric conversion efficiency.

To attain the above object, the present invention provides a solar cell arrangement including a plurality of elongate solar cell elements each having an elongate first electrode and a photovoltaically operative layer disposed coaxially around said first electrode, said solar cell elements each having an outer peripheral surface, and a generally plate-like second electrode having one side surface on which the solar cell elements are mounted, characterized in that said one side surface of said second electrode is a light-reflective surface configured such that light reflected from it is gathered onto the outer peripheral surfaces of said solar cell elements.

In one embodiment of the invention, the one side surface of the second electrode comprises a plurality of concave surfaces formed on the one side surface in a fashion such as to be associated with respective ones of the solar cell elements, the concave surfaces being configured and disposed such that light reflected from each of the concave surfaces is gathered onto the outer peripheral surfaces of the associated one of the solar cell elements.

Preferably, the solar cell elements are arranged on the one side surface of the second electrode in mutually parallel juxtaposed relationship, the concave surfaces in mutually parallel juxtaposed relationship in a direction identical with the direction of the arrangement of the solar cell elements, the solar cell elements being mounted on respective ones of the concave surfaces.

Preferably, the concave surfaces extend at least along the whole length of the solar cell elements.

In another embodiment of the invention, the one side surface of the second electrode has formed thereon a ridge having a substantially triangular cross section interposed between each pair of adjacent ones of the solar cell elements, each said ridge being configured and disposed such that light reflected from the ridge is gathered onto the outer peripheral surface of the associated pair of the solar cell elements.

Preferably, the said ridges extend at least along the whole length of the solar cell elements.

In a further embodiment of the invention, the one side surface of the second electrode has formed thereon a ridge-like projection at a central portion of each of the concave surfaces, on which an associated one of the solar cell elements is supported.

Preferably, the said ridge-like projections extend at least along the whole length of the solar cell elements.

Preferably the said first electrodes, and indeed the solar cell elements incorporating the same, are of a thread-like configuration.

Some embodiments of the invention will now be described by way of example and with reference to the accompanying drawings, in which:-
Fig.1 is a perspective view of a conventional solar cell arrangement;
Fig.2 shows a fragmentary front view of the conventional solar cell arrangement of Fig.1, useful in explaining how shaded portions are formed depending on the direction of incident light L;
Fig.3 is a perspective view of a solar cell arrangement according to an embodiment of the invention;
Fig.4 shows a fragmentary front view of the solar cell arrangement of Fig.3;
Fig.5 shows a fragmentary front view of a solar cell arrangement according to a further embodiment of the invention; and
Fig.6 shows a fragmentary front view of a solar cell arrangement according to another embodiment of the invention.

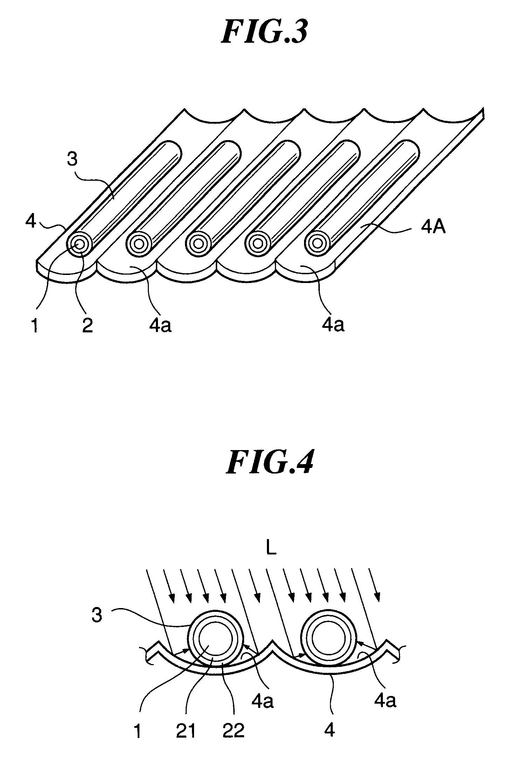

Referring first to Fig.3, the solar cell arrangement according to this embodiment is comprised of a plurality of wire-like or thread-like solar cell elements 3 which are arranged in mutually parallel juxtaposed relationship and which each comprise a wire-lie or thread-like center electrode 1 as a positive electrode, a photovoltaically operative layer 2 disposed coaxially around the center electrode 1, and a generally plate-like electrode 4 as a negative electrode on which the solar cell elements 3 are mounted.

As shown in Fig.4, the photovoltaically operative layer 2 is comprised of an n-type semiconductor layer 21 disposed coaxially around the center electrode 1, and a p-type semiconductor layer 22 disposed coaxially around the n-type semiconductor layer 21. The photovoltaically operative layer 2 may further comprise a semiconductor layer, not shown, disposed coaxially directly around the center electrode 1, a a barrier or junction layer, not shown, interposed between the semi-conductor layer and the n-type semiconductor layer 21, and a protective cover layer, not shown, disposed around the p-type semiconductor layer. The negative electrode 4 is in direct contact with the outer peripheral surface of each solar cell element 3 to serve as a common negative electrode for all the solar cell elements 3. The negative electrode is preferably formed of a light-reflective electrically conductive material.

According to the embodiment, the negative-electrode 4 has a light-reflective side surface 4A on which the solar cell elements 3 are mounted, and the light-reflective surface 4A is configured such that light reflected from the light-reflective surface is converged or gathered on the outer peripheral surface of each solar cell element 3. More specifically, the negative electrode 4 is generally corrugated such that a plurality of elongate concave surfaces 4a are formed over the light-reflective side surface 4A of the negative electrode 4. The concave surfaces 4a each extend longitudinally of the solar cell arrangement, preferably over the whole length of the negative electrode 4, which is slightly larger than the length of each solar cell element 3, and are arranged in mutually parallel juxtaposed relationship in the same direction as the direction in which the solar cell elements 3 are arranged. The solar cell elements 3 are mounted on the respective light-reflective surfaces 4a in a fashion extending in the lengthwise direction thereof. The curvature of each light-reflective surface 4a is set such that incident light reflected from the surface 4a is converged on opposed portions of the outer peripheral surface of the solar cell element 3.

Positive lead wires, not shown, are connected to the positive electrodes 1 of the solar cell elements 3 to electrically connect the positive electrodes 1 together, while a negative lead wire, not shown, is connected to the negative electrode 4.

With the above arrangement of the invention, no shaded portion is formed irrespective of the direction of incident light L, and the plate-like negative electrode 4 serves as a condenser plate as well such that incident light L is reflected by the concave light-reflective surfaces 4a and the reflected light is gathered onto the outer peripheral surfaces of the wire-like solar cell elements 3. Thus, the solar cell elements 3 have almost the entire outer peripheral surfaces thereof irradiated by light, i.e. direct rays of incident light and reflected light, resulting in enhanced photoelectric conversion efficiency. Therefore, the number of the solar cell elements 3 used to obtain a required amount of electromotive force can be decreased, leading to an improved space factor as well as a reduced manufacturing cost.

Moreover, the solar cell arrangement according to the invention can dispense with the use of a separate condenser plate, by utilizing the plate-like negative electrode 4 as a condenser plate as well, which simplifies the whole construction of the solar cell arrangement, as well as enables designing the solar cell arrangement compact in size and light in weight.

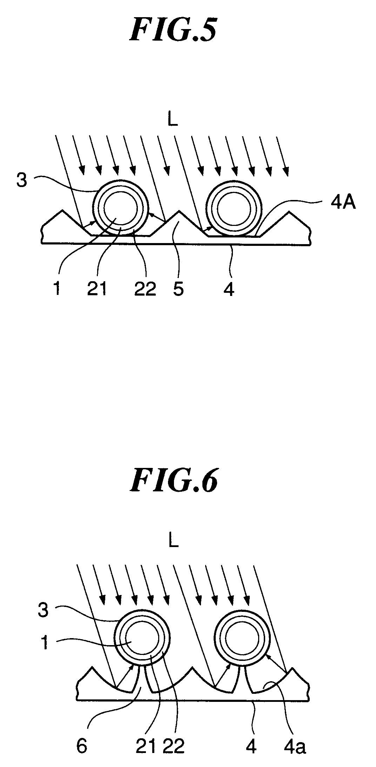

Fig. 5 shows a solar cell arrangement according to a further embodiment of the invention. In this embodiment, to gather reflected light onto the outer peripheral surface of each solar cell element 3, a ridge 5 having a triangular cross section is formed integrally on the side surface 4A of the electrode 4 on which the solar cell elements 3 are mounted, at a location between each pair of adjacent solar cell elements 3, the ridge 5 extending longitudinally of the solar cell arrangement, preferably over the whole length of the negative electrode 4. The portion of the side surface of the electrode 4 on which each solar cell element 3 is mounted is flat. Each of the opposite sloped lateral surfaces of the ridge 5, which are flat, faces toward the associated solar cell element 3 such that light reflected from the sloped lateral surface impinges on an opposed portion of the outer peripheral surface of the associated solar cell element 3.

Fig. 6 shows a solar cell arrangement according to another embodiment of the invention. This embodiment is distinguished from the aforedescribed Fig. 3 embodiment in that a ridge-like projection 6 is formed integrally on each concave surface 4a at a transversely central portion thereof, the ridge-like projection 6 extending longitudinally of the solar cell arrangement, preferably over the whole length of the negative electrode 4. The associated solar cell element 3 is supported on the ridge-like projection 6. According to this embodiment, incident light reflected from the concave surface 4a can impinge on lowermost portions of the outer peripheral surface of the solar cell element 3, to further enhance the photoelectric conversion efficiency. In place of the ridge-like projection 6, a plurality of ridge-like projections which are much shorter in length may be formed on each concave surface 4a in serially spaced arrangement along the length thereof.

Even with the arrangements according to the Fig. 5 and Fig. 6 embodiments, similar or more excellent results described previously with respect to the Fig. 3 embodiment can be provided.

Further, according to the solar cell arrangement of the invention, the positive electrode 1 in the form of a wire is arranged in the interior of the photovoltaically operative layer 2, instead of being arranged on the surface of the same, as is distinct from the conventional solar cell. As a result, the photovoltaically operative layer 2 is not shaded by the positive electrode 1, which also contributes to achievement of efficient irradiation of incident light. Besides, the solar cell element 3 is in the form of a wire or a thread and formed substantially solely of the positive electrode 1 and the photovoltaically operative layer 2, which makes it possible to easily manufacture the solar cell element 3 in a continuous manner. Moreover, the positive electrode 1, which is formed of a wire, has smaller electric resistance than that of a thin film-shaped electrode employed in the conventional solar cells, resulting in an increased photoelectromotive force. Thus, the solar cell arrangement according to the invention can enjoy the above-mentioned advantages and excellent results achieved by the formation of the positive electrode and the photovoltaically operative layer in the form of wires. Although in the above described embodiments, the generally plate-like negative electrode 4 is formed of a light-reflective material, alternatively the side surface on which the solar cell elements are mounted may be coated with a light-reflective coating material.

## Claims

1. A solar cell arrangement including a plurality of elongate solar cell elements (3) each having an elongate first electrode (1) and a photovoltaically operative layer (2) coaxially disposed around said first electrode, said solar cell elements each having an outer peripheral surface, and a generally plate-like second electrode (4) having one side surface (4A) on which said solar cell elements are mounted,
characterised in that:
said one side surface of said second electrode is a light-reflective surface which is configured such that light reflected from it is gathered onto said peripheral surfaces of said solar cell elements.

2. A solar cell arrangement is claimed in claim 1, wherein said one side surface of said second electrode (4) comprises a plurality of concave surfaces (4a) formed on said one side surface (4A) in a fashion such as to be associated with respective ones of said solar cell elements (3), said concave surfaces being configured and disposed such that light reflected from each of said concave surfaces is gathered onto said outer peripheral surface of the associated one of said solar cell elements.

3. A solar cell arrangement as claimed in claim 2, wherein said solar cell elements (3) are arranged on said one side surface (4A) of said second electrode in mutually parallel juxtaposed relationship, said concave surfaces (4a) comprising a plurality of elongate concave surfaces arranged on said one side surface of said second electrode in mutually parallel juxtaposed relationship in a direction identical with the direction of said arrangement of said solar cell elements, said solar cell elements being mounted on respective ones of said concave surfaces.

4. A solar cell arrangement as claimed in claim 3, wherein said concave surfaces (4a) extend at least along the whole length of said solar cell elements (3).

5. A solar cell arrangement as claimed in any of claims 2 to 4, wherein said one side surface (4A) of said second electrode (4) has formed thereon a ridge-like projection (6) at a central portion of each of said concave surfaces (4a), on which an associated one of said solar cell elements (3) is supported.

6. A solar cell arrangement as claimed in claim 5, wherein said ridge-like projections (6) extend at least along the whole length of said solar cell elements (3).

7. A solar cell arrangement as claimed in claim 1, wherein said one side surface (4A) of said second electrode (4) has formed thereon a ridge (5) having a substantially triangular cross section interposed between each pair of adjacent ones of said solar cell elements (3), each said ridge being configured and disposed such that light reflected from said ridge is gathered onto said outer peripheral surfaces of its associated pair of said solar cell elements.

8. A solar cell arrangement as claimed in claim 7, wherein each said ridge (5) extends at least along the whole length of said solar cell elements (3).

9. A solar cell arrangement as claimed in any preceding claim, wherein said first electrodes (1) are of a thread-like configuration.

10. A solar cell arrangement as claimed in any preceding claim, wherein said solar cell elements (3) are of a thread-like configuration.
